# EUROPEAN PATENT APPLICATION

(11) **EP 2 302 697 A1**
(43) Date of publication of application: **30.03.2011**
(21) Application number: 09171144.0
(22) Date of filing: 23.09.2009
(51) Int. Cl.: H01L 31/052, H01L 31/18

(54) **Solar cell and its production process**

(71) Applicant: École Polytechnique Fédérale de Lausanne (EPFL), 1015 Lausanne (CH)
(72) Inventor: Haug, Franz-Joseph, 2072, Saint-Blaise (CH); Sweetnam, Sean, Madison, WI 53713 (US); Ballif, Christophe, 2000, Neuchâtel (CH); Söderström, Thomas, CH-1026 Denges (CH)
(74) Representative: GLN

(57) **Abstract**

The present invention relates to a solar cell comprising a support (6), a back electrode layer (5), at least a hydrogenated microcrystalline silicon photoelectric device (9), and a top electrode layer (11). The back electrode layer (5) has a rough surface. The solar cell comprises, between the back electrode layer (5) and the hydrogenated microcrystalline silicon photoelectric device (9), an asymmetric intermediate layer (8), said intermediate layer (8) being adjacent to said hydrogenated microcrystalline silicon photoelectric device (9) and having a surface, on the side of the back electrode layer (5), having a roughness greater than the roughness of the surface of said intermediate layer (8) on the side of the hydrogenated microcrystalline silicon device (9).
Such solar cells allow to obtain optimum Voc and FF parameters, while maintaining high current.

## Description

### Technical Field

The present invention relates to the field of solar cells. More particularly, it relates to a solar cell comprising a support, a back electrode layer, at least a hydrogenated microcrystalline silicon photoelectric device, and a top electrode layer. It relates also to a solar cell comprising a stack of amorphous silicon or silicon alloys photoelectric devices (absorbing blue to red light, possibly infrared with SiGe alloys) and microcrystalline photoelectric devices (absorbing red to infrared). Such cells are called multiple-junction cells. The invention also relates to a method for producing this solar cell.

A particularly advantageous application of the present invention is for the production of photovoltaic cells intended for generating electrical energy, but the invention also applies, more generally, to any structure in which light radiation is converted into an electrical signal, such as photodetectors.

### Background of the invention

Hydrogenated microcrystalline silicon (µc-Si:H) can be used in conjunction with hydrogenated amorphous silicon (a-Si:H) to produce so called "micromorph" cells which can more efficiently utilize the full solar spectrum than a single junction a-Si:H or µc-Si:H device. In the case of both a-Si:H and µc-Si:H, it is desirable to have the thinnest effective absorber layer possible. This desire for thinness is due in part to the well known light induced degradation (LID) or Staebler-Wronski effect present in a-Si:H, and is also due to a desire to decrease material use in thin film silicon solar cells. In addition, µc-Si:H begins to suffer reductions in open circuit voltage (Voc) and fill factor (FF) when the absorber layer thickness is larger than approximately 4-6 µm.

Thinner absorber layers, however, will absorb less of the incident light and will reduce a cell photocurrent. Light trapping provides a solution to the problem of reduced light absorption. Light trapping is obtained by introducing a structure, either by having a glass coated with a transparent and nanotextured material or by coating an opaque substrate with a rough reflecting structure. When going through the film the light is scattered at the rough interfaces. This scattering can increase the effective path length through the absorber layer (if the diffusion takes place at high angle) and can lead to multiple internal reflections in the devices. These both effects combined lead to light trapping and can multiply the effective thickness of the absorber layer without requiring an increase in the actual absorber layer thickness. Typical values for the total light path enhancement of 5-20 are reported in the literature. The typical size and roughness of the features required for light trapping are in the range of 100-300 nm lateral feature size for a-Si:H with rms roughness in the range of 30-200 nm, and 200-2000 nm for µc-Si and rms roughness in the range of 50-500 nm for µc-Si:H.

In the configuration, several materials have been found to work well with a-Si:H and µc-Si:H for light scattering: natively textured SnO₂ deposited by APCVD, sputtered-etch ZnO, low pressure chemical vapor deposition (LPCVD) ZnO. For instance, LPCVD ZnO has a naturally rough surface with pyramidal features which scatters light. The pyramid characteristics can be modified via deposition parameters, resulting in control over which wavelengths are preferentially scattered by the ZnO. Moreover, high internal reflection and indeed total internal reflection is possible at the interface of a-Si:H / µc-Si:H and ZnO. Thus ZnO provides good light trapping when used in conjunction with hydrogenated silicon cells.

In all generality though there is strong drawback of most light scattering schemes. A strong problem that occurs in the realization of devices is that, when rough structures are introduced to realize a strong light scattering, they also tend to create defects in the absorber layers of the solar cell which are grown subsequently, which can be called cracks. This effect is quite universal and applies for all rough (root mean square rms > 20 nm) superstrates and substrates electrodes presenting "sharp" features in the sense of valley with short radius of curvature (typically smaller than 100 nm). This is particularly true for the µc-Si:H device which is particularly affected by substrate morphology.

In particular µc-Si:H deposited on rough LPCVD ZnO, or rough SnO, or rough pyramidal structures suffers from losses in Voc and FF which are caused by crack formation resulting from the rough substrate morphology. As almost always, for instance when increasing the roughness of the ZnO does increase the short circuit current (Jsc) of cells prepared on rough LPCVD ZnO, but the efficiency is not maximized due to the losses in Voc and FF. Conversely, µc-Si:H cells prepared on flat substrates show very high Voc and FF, but suffer from sub-optimal Jsc. This is also true for solar cells prepared on opaque backreflectors.

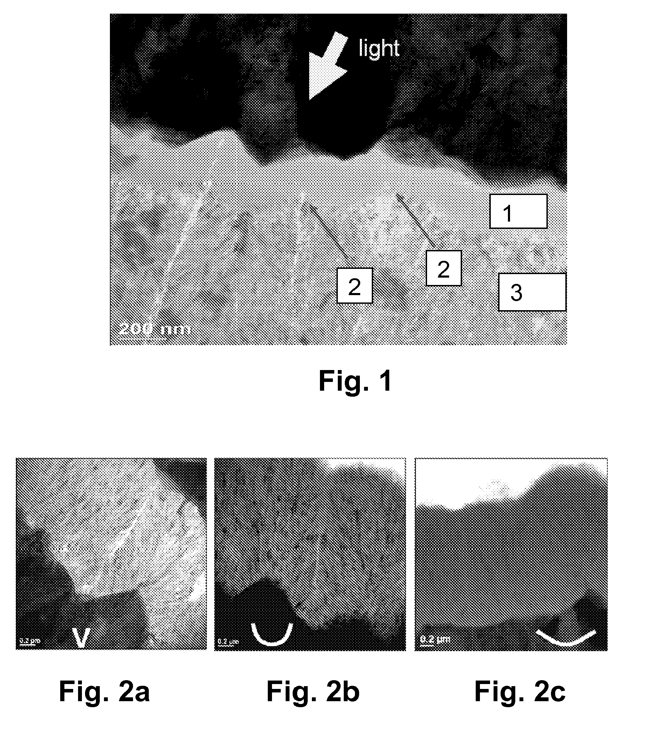

This effect, which is detrimental for microcrystalline cell, can appear quite strongly in micromorph cells. As shown by Figure 1, after the growth of the amorphous top cell 1, cracks 2 continue to propagate or even start to grow in the microcrystalline layer 3. This leads to strong reduction of Voc and FF. Indeed many productions line worldwide are fighting with this effect.

Some solutions have been found to solve this problem.

One of the solutions in the case of the p-i-n superstrate configuration, when the TCO presents sharp valleys, is to apply a plasma treatment that will smooth the bottom of the valleys. As shown by Figures 2a to 2c, µc-Si:H p-i-n devices on substrates are treated with increasing plasma treatment time (Fig. 2a: 0 min; Fig. 2b: 40 min; Fig. 2c: 80 min). At 0 min, cracks go through the full devices, for 40 min of treatment, the cracks do not cross completely through the p-i-n device (compare with sample t = 0 min), but only begin after the first third of the i-layer.

If the radius of curvature at the bottom of the valley is reduced, the Voc and FF are increased. A disadvantage is that the current diminishes. Hence there is an optimum, trade-off between current and Voc and FF.

Another standard solution is to decrease the roughness of the front transparent conductive oxide layer. If the roughness is diminished the action of the cracks will be reduced and the amorphous cell will even tend to slightly smooth out the initial surface. Also in this case the total current (sum of top cell + bottom cell current) is diminished. Again, a certain optimum roughness of TCO will give a best compromise to have the highest efficiency.

In all cases it seems to be very difficult to find a texture that would allow a very good light trapping, both in the amorphous and in the microcrystalline cells. The sputter-etched system has features which are crater-like and better suited for the growth of microcrystalline. In this case however, it is more difficult to achieve a high enough current in the top cells, even after introduction of an intermediate reflector.

In conclusion, ideal substrate and device configurations which would allow both a fantastic light trapping (High Jsc) and optimum other parameters (Voc and FF), does not exist yet. Furthermore an ideal structure that would give high current in the both subcell components does not exist yet.

### Summary of the invention

The present invention provides a solar cell which allows to avoid the disadvantages of the prior art.

Accordingly, the present invention relates to a solar cell comprising a support, a back electrode layer, at least a hydrogenated microcrystalline silicon photoelectric device, and a top electrode layer. The back electrode layer has a rough surface, and has been, for example, textured. The solar cell comprises, between the back electrode layer and the hydrogenated microcrystalline silicon photoelectric device, an asymmetric intermediate layer, said intermediate layer being adjacent to said hydrogenated microcrystalline silicon photoelectric device and having a surface, on the side of the back electrode layer, having a roughness greater than the roughness of the surface of said intermediate layer on the side of the hydrogenated microcrystalline silicon device.

In some preferred embodiments, the roughness of the surface of the intermediate layer on the side of the hydrogenated microcrystalline silicon device, determined by the standard deviation of the heights of the points constituting its surface, may be comprised between 0 nm and 30 nm, or between 1 nm and 30 nm.

In other embodiments, if valleys are present on the surface, the roughness of the surface of the intermediate layer on the side of the hydrogenated microcrystalline silicon device, determined by the standard deviation of the heights of the points constituting its surface, may be comprised between 10 nm and 200 nm, and the radius of curvature at the bottom of the valleys or pinches may be larger than 50 nm, preferably 100 nm.

Preferably, the roughness of the surface of said intermediate layer on the side of the back electrode layer, determined by the standard deviation of the heights of the points constituting its surface, may be comprised between 50 nm and 300 nm. Advantageously, the roughness of the surface of said intermediate layer on the side of the back electrode layer may be such as to promote the best light trapping in the device and will be the same, in case of substrate growth, as the underlying back electrode with typical features of size L in the range of 200-2000 nm, opening angles in the range of 0-30° and height H corresponding, with equivalent rms in the range of 30-500 nm.

Advantageously, as the intermediate layer may lead to parasitic light absorption, it should have a thickness as small as possible to obtain the desired effect, typically of between 0.05 µm and 1 µm, preferably between 0.1 µm and 0.4 µm.

Preferably, the intermediate layer may have a refractive index n close to that of crystalline silicon (n = 4), n being preferably comprised between 3 to 3.7, but an extinction coefficient k smaller than the one of crystalline Si in the region of interest.

Advantageously, the intermediate layer may be made of amorphous silicon optionally alloyed with carbon, oxygen, or nitrogen or a combination of those.

In some embodiments, the support may be a substrate on which the back electrode layer is deposited.

In such embodiments, the solar cell may further comprise, between the microcrystalline silicon device and the top electrode layer, at least one photoelectric device based on amorphous silicon, in order to form a multi-junction cell. An intermediate reflector may be deposited between the photoelectric device based on amorphous silicon and the microcrystalline silicon device. A photoelectric device based on amorphous silicon means one amorphous Si cell but also alloys of amorphous Si (e.g. alloyed with Ge or C or O) and a stack of several amorphous cells.

In some embodiments, the support may be transparent, the top electrode layer being deposited on said support and the solar cell further comprises, between the top electrode layer and the microcrystalline silicon device, at least a photoelectric device based on amorphous silicon, in order to form a multi-junction cell. An intermediate reflector may be deposited between the photoelectric device based on amorphous silicon and the microcrystalline silicon device, said intermediate reflector having, on the side of the microcrystalline silicon device, a roughness that is not detrimental to the growth of the microcrystalline cell. It can typically be comprised between 10 nm to 30 nm, preferably between 1 and 30 nm and should be as flat as possible, in the sense that no sharp valleys with radius of curvature smaller than 100 nm should be present. In this case the light trapping in the µc-Si cell might be insufficient but can be compensated with the introduction of backdiffuser later in the device. Or the roughness of the intermediate reflector, on the side of the microcrystalline silicon device, may be comprised between 10 nm and 200 nm and the radius of curvature at the bottom of the valleys or pinches may be larger than 50 nm, preferably 100 nm.

The intermediate reflector may incorporate on the side of the microcrystalline silicon device an electrically inactive Si based layer, which is deposited on the low refractive index material of the intermediate reflector, and which is smoothed in order to achieve the required roughness and morphology of the intermediate reflector defined above.

Such a solar cell allows to prevent reduction of the electrical parameters in thin film solar. The aim of the invention is to create structure of the solar cell so that the microcrystalline cell is grown on a surface layer, adjacent to the microcrystalline cell, as flat as possible, but still can benefit from a strong light trapping effect. It is proposed a decoupling of light trapping and cell growth conditions.

This structure has the potential to increase the efficiency of thin film solar cells, especially those based on micromorph concept.

The present invention relates also to a method for producing an embodiment of a solar cell as defined below, said method comprising the following steps of:
- providing a substrate on which a textured back electrode layer has been deposited,
- depositing on the textured back electrode layer an intermediate layer,
- smoothing the surface of said intermediate layer until to obtain a roughness of the surface of the intermediate layer lower than the roughness of the surface on the side of the textured back electrode layer, and
- depositing on the intermediate layer at least a hydrogenated microcrystalline silicon layer forming a photoelectric device, and
- depositing the top electrode layer.

Advantageously, the step of smoothing the surface of the intermediate layer is carried out until point contacts with the back electrode layer are created.

In some embodiments, the method may further comprise a step of depositing, between the microcrystalline silicon photoelectric device and the top electrode layer, at least one photoelectric device based on amorphous silicon (amorphous silicon or amorphous silicon alloys (e.g. SiCₓ, SiGeₓ, SiOₓ)), in order to form a multi-junction cell. It may also further comprise a step of depositing, between the photoelectric device based on amorphous silicon and the microcrystalline silicon photoelectric device, an intermediate reflector.

The present invention relates also to a method for producing another embodiment of a solar cell as defined below, said method comprising the following steps of:
- providing a support on which a top electrode layer has been deposited,
- depositing on the top electrode layer at least one photoelectric device based on amorphous silicon,
- depositing at least one hydrogenated microcrystalline silicon photoelectric device,
- depositing on said hydrogenated microcrystalline silicon photoelectric device an intermediate layer,
- texturing the surface of said intermediate layer until to obtain a roughness of the surface of the intermediate layer greater than the roughness of the surface on the side of the hydrogenated microcrystalline silicon photoelectric device, and leading to light trapping inside the microcrystalline device and
- depositing the back electrode layer.

Advantageously, the method may further comprise a step of depositing, between the photoelectric device based on amorphous silicon and the microcrystalline silicon photoelectric device, an intermediate reflector having, on the side of the microcrystalline silicon device, a roughness that is not detrimental to the growth of the microcrystalline silicon device, as defined above.

### Brief description of the drawings

Figure 1 is a TEM (transmission electron microscopy) cross-section micrograph of micromorph cells of the prior art,

Figures 2a, 2b, and 2c are bright field TEM cross-section micrographs of µc-Si:H p-i-n devices of the prior art, deposited on substrates and treated with increasing plasma treatment time,

Figures 3a and 3b are schematic cross-section views of a solar cell of the invention,

Figure 4a is a schematic cross-section of a substrate used in the solar cell of the invention,

Figure 4b is a top view of Figure 4a,

Figures 5 and 6 are schematic cross-section views of micromorph solar cells of the invention,

Figure 7 is a schematic cross-section view of micromorph solar cell of the prior art, and

Figure 8a and 8b are SEM images of LPCVD ZnO layer with intermediate layer material deposited on it both pre (a) and post (b) polishing.

### Detailed description

In the present description, the term "back electrode layer" means the electrode layer or the electrode system layers which is the farthest away from the incoming light side. It is usually associated with a backreflector effect, to reflect the light in the cell. The term "top electrode layer" means the electrode layer or the electrode system layers which is the closest to the incoming light side.

Case A: cell fabrication on a highly reflective electrode (substrate configuration)

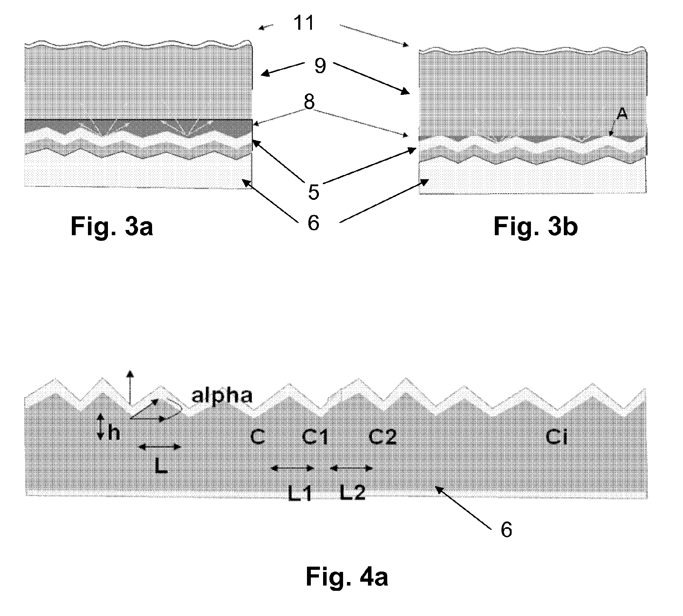

Figures 3a and 3b illustrate the invention in the case of a single junction solar cells deposited on a textured back electrode system 5 which is highly reflective. The back electrode layer is deposited on a substrate 6. On the back electrode layer 5, first a smoothing intermediate layer 8 with an index of refraction close to those of µc-Si:H in the region of interest. The intermediate layer 8 is typically a-Si:H possibly phosphorous doped and possibly alloyed with C or O to slightly decrease its absorbance in the range of interest (600-1100 nm typically) with index of refraction in the range 3.7-3 in order to be optically transparent. It will absorb less than µc-Si in the region of interest.

Then the smoothing intermediate layer 8 is smoothed, down to a roughness of 1-30 nm, by mechanical polishing or plasma etching, so that the intermediate layer 8 is smooth enough to allow a perfect growth of the µc-Si:H cell 9 (Fig. 3a). To ensure a good electrical conductivity to the back-side of the µc-Si:H cell 9, either the smoothing intermediate layer 8 is slightly doped, or it is smoothed until point contacts A with the back conductive electrode 5 are created (see Fig. 3b), typically 0.1-10 contacts points per µm² of cell area. A good control of the properties of the smoothing intermediate layer 8 is essential to avoid too high parasitic losses or too strong refraction effects at the boundaries between the cell and this layer. Smoothing occurs typically through mechanical polishing, chemical polishing or plasma etching or a combination of the methods.

Then a top electrode layer 11, as TCO, is deposited on the µc-Si:H cell 9.

Figures 3a and 3b show, in the case of a µ-crystalline cell 9, how the light trapping is decoupled from the geometry of the rough electrode 5.

The shape of the substrate 6 to achieve good light trapping properties is also important.

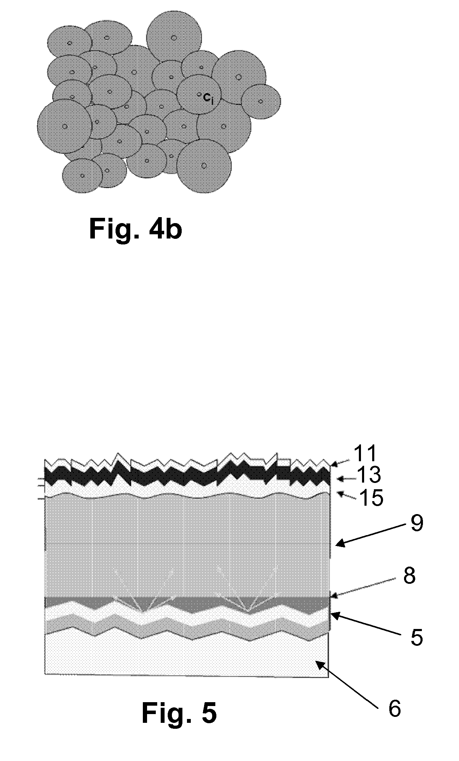

Typically, in reference to Figure 4a, the substrate 6 will have features size in the range L of 200-2000 nm, opening angles in the range of 5-30° and height H corresponding. The back electrode 5 and the intermediate layer 8 on the side of the back electrode layer 5, will have similar geometry. The choice of the typical length L and opening angle alpha depends on the thickness of the cell W and on the cell configuration (substrate, superstrate, single junction or micromorph). The center of the structures is typically at a distance L from the next structure and there is a distribution of distance Li between the centers Ci with a Gaussian distribution of standard deviation smaller than L/4. The structure will appear to have a random distribution over the surface for larger values of this standard deviation and periodic for smaller values. Seen from the top, as in Figure 4b, the structure can be linear, but preferably two dimensional. In this case the structures can be conical, pyramidal, or quadratic, or any shape that favours the light trapping in the device. Also the shapes from TCO that gives good Jsc values in standard devices in the superstrate configuration can be used, possibly with a liner reduction of their height. Noticeably a structure with the cone can relax the condition on the smoothing layer, as in the worst case only a one dimensional crack would extend into the solar cells (originating from the center of the cone). In the case, it can be sufficient that the smoothing layer 8 fills the cones and ensures a radius of curvature > 100 nm to ensure a good device working.

The materials constituting the back electrode system 5 or the back reflector can be typically Ag covered with 40-120 nm of ZnO, doped SiOₓ or another slightly conductive dielectric or transparent conductive oxide. It can also be a construction with a structured TCO on glass, with a metal or white dielectric back reflector at the back of the glass, or a mirror between the glass and the rough TCO.

In another embodiment, as shown in Figure 5, an amorphous silicon top cell 13 is added to the µc-Si:H cell 9 of Figures 4a, 4b to form a micromorph cell of the invention. Then, an asymmetric reflector 15 can be added between the amorphous silicon cell 13 and the µc-Si:H cell 9 to allow a strong light trapping in the top cells. Alternatively, instead of one a-Si top cell several amorphous cells based on Si, Ge, C, can be used to form a multi-junction device.

Case B: cell fabrication in superstrate configuration (light enters through the glass)

In this case, it is not possible to apply the same technique on the front TCO, as the smoothing layer would absorb most of the light. One typical possibility is shown to realize better devices.

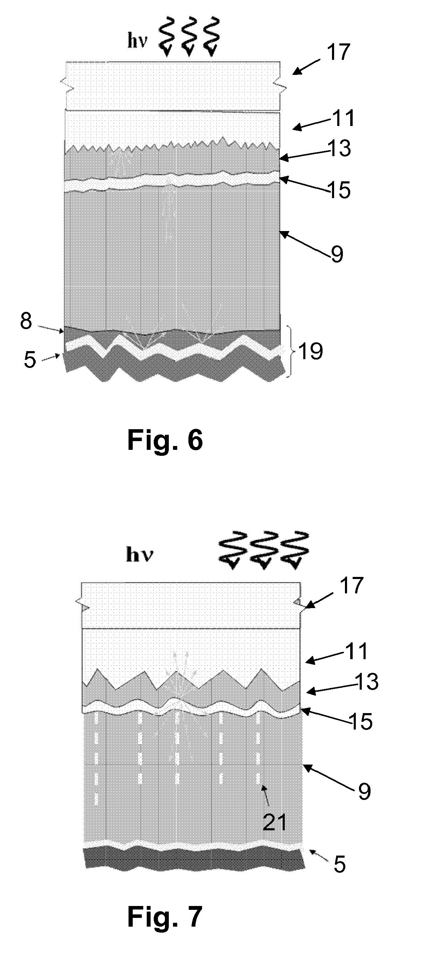

In reference to Figure 6, a TCO, constituting the top electrode 11 is deposited on glass 17. Such TCO 11, with small lateral features sizes is selected, typically 100-300 nm. It has the minimum roughness required so that, after deposition of the a-Si layer 13 and of the intermediate reflector 15 (typically 50-150 nm of SiOx, or ZnO or a combination) a high current is generated in the top cell, typically 12-15 mA/cm2, but also that the surface has a minimum roughness, suitable for a perfect growth of µc-Si cell 9. This means that the typical roughness in the range of 10-30 nm, and that no strong pinches or valley exist. Alternative the intermediate reflector 15 can be smoothed further by a chemical or plasma etching process, or can be polished mechanically. Before this smoothing, an inactive amorphous or microcrystalline layer can also be deposited on the low refractive index material of the intermediate reflector, so that the optical effect of the intermediate reflector remains maximum.

Smaller features are more effective than larger to achieve a strong courant incoupling into the amorphous top cell 13. Note that in the configuration of Figure 6, the light is poorly scattered in the infrared part of the spectrum. This is not the case for the classical device as shown in Figure 7, where scattering in the IR is possible by the front TCO but at the cost of inducing cracks 21 in the µc-Si device 9.

Then a perfect microcrystalline cell 9 is grown. After the growth a backside structure is fabricated with the same properties as described in the case A, and all propositions of case A also apply. This time, the intermediate layer 8 is not called smoothening layer, but structured layer, as a diffusing structure called backscatterer 19 need to be introduced at the backside. They are different ways to realize the backscatterer 19. For instance, the structured intermediate layer 8 can be etched chemically, or using a masking step, or with a plasma etching process or by a combination of those. After structuring the structured intermediate layer 8, typically a backreflector comprising the back electrode layer 5 will be added. All the preferred patterns described in A should be preferably applied to generate structures that promote an efficient light trapping in the µc-Si cell.

Eventually, the device will allow to decouple the light trapping in the top and bottom cells. The best electrical properties and current of each subcomponent cells should be achievable.

Example:

The following example illustrates the present invention without however limiting the scope.

Objectives

The goal of this experiment was to create a substrate that was flat, in order to produce high quality, crack free µc-Si:H material with high Voc and FF, but which still retained the light trapping and scattering properties of rough LPCVD ZnO. The proposed method to create such a substrate is as follows: a standard rough LPCVD ZnO substrate is coated with the called intermediate layer of phosphorous doped a-Si:H alloyed with either carbon or oxygen. The alloying process allows some tuning of the bandgap (and hence optical absorption) and index of refraction of the intermediate layer. This layer is then mechanically polished to remove the texture imparted to the intermediate layer by the LPCVD ZnO underneath. An ideal intermediate layer could thus provide a flat surface after polishing, and would also have an appropriate index of refraction and a sufficiently high bandgap that it would not interfere with the LPCVD ZnO's light trapping properties, and would absorb very little incident light.

Materials and techniques

The initial substrates used were Schott AF 45 glass coated with LPCVD ZnO. The intermediate layers were deposited on the substrates using VHF PECVD in a single chamber reactor system (system A).

Polishing was performed by hand using Struers DP-NAP cloth (DP-NAP) as a polishing cloth and Struers OP-S colloidal silica polishing solution (OP-S). The particles in the polishing solution had a diameter of 0.04 µm.

µc-Si:H cell deposition was performed using VHF PECVD in a two chamber reactor system (system B). One reactor was used exclusively for doped layer deposition, and the other was used exclusively for intrinsic material deposition. Deposition temperatures in both system A and B were lower than 200° C to permit future applications with flexible substrates.

The current-voltage (I-V) characteristics are measured with standard conditions of AM 1.5g illumination. The solar spectrum is reproduced with a dual lamp (halogen, xenon) solar simulator (class A, WACOM). The crystalline volume fraction (CVF) of µc-Si:H absorber layers was determined by Raman spectroscopy performed using a Renishaw Ramascope in the back scattering configuration with a green laser (514 nm), which has a penetration depth of approximately 150 nm in µc-Si:H material. Material thickness was determined using an Ambios XP-2 contact profilometer. Index of refraction was determined via ellipsometry using a Horiba Jobin Yvon Uvisel system. A JEOL JSM-7500TFE field emission scanning electron microscope (SEM) was used to compare polished and unpolished substrate morphologies.

Cell Development

The cell structure used in this experiment is shown by Figure 3b. It comprised:
- a substrate 6 which was Schott AF 45 glass
- a back electrode layer 5 which was a low pressure chemical vapor deposition (LPCVD) ZnO layer
- an intermediate layer 8 (n-a-Si₁₋ₓCₓ:H or n-a-Si_{1-y}O_{y}:H)
- a µc-Si:H photoelectric device 9 comprising a phosphorous doped µc-Si:H <n> layer, a µc-Si:H <i> layer and a boron doped µc-Si:H <p> layer
- a top electrode layer 11 which was a LPCVD ZnO.

Cells were deposited on Schott 45 glass / LPCVD ZnO / intermediate layer (n-a-Siᵢ₋ₓCₓ:H or n-a-Si_{1-y}O_{y}:H) substrates. Typical peak to valley heights ranges for LPCVD ZnO are on the order of 500 nm, thus approximately 600 nm of material was deposited as the intermediate layer.

n-a-Si₁₋ₓCₓ:H intermediate layer materials were prepared by adding CH₄ to standard n-a-Si:H plasma, and n-a-Si_{1-y}O_{y}:H intermediate layer materials were prepared by adding CO₂ to standard n-a-Si:H. Such intermediate layers have an index of refraction greater than 3.0.

Such intermediate layer 8 had undergone the polishing process. The cells were deposited in system B at temperatures lower than 200° C. The cells discussed in this example had absorber layers with a thickness of 1.5 or 2.5 µm. Following cell deposition, LPCVD ZnO was deposited as a top contact.

Results

Polishing Process

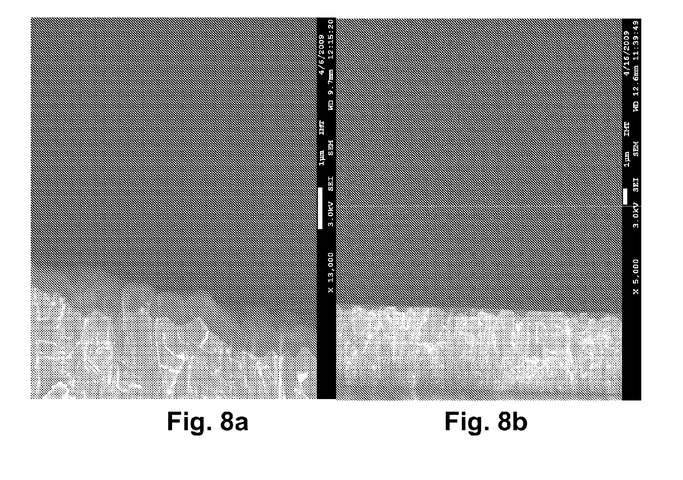

Scanning electron miscroscope (SEM) images were used to determine if the polishing process was effective. Figure 8 shows SEM images of substrates coated with intermediate layers before and after the polishing process.

The image of the substrates prior to polishing (figure 8a) shows that the morphology of the LPCVD ZnO is roughly maintained by the n-a-Si:H. Moreover, the intermediate layer successfully fills in the LPCVD ZnO valleys, and is present from peak to valley.

The image of the substrates following the polishing process (figure 8b) demonstrates that the polishing process successfully creates a flat surface by removing the rough morphology maintained by the n-a-Si:H. In addition, some of the LPCVD ZnO pyramid peaks are exposed by the polishing process, which may facilitate charge extraction from the device to the back contact. However, this may also impede the scattering capabilities of ZnO as it has been found that the pyramid peaks may be responsible for the majority of ZnO's light scattering properties.

Cell Performance

The I-V results and CVF for cells prepared with the n-a-Si₁₋ₓCₓ:H and n-a-Si_{1-y}O_{y}:H intermediate layers are presented in Table 1. Cells were prepared with absorber layer thicknesses of either 1.5 or 2.5 µm. Reference cells were also prepared on an in-house Schott 45 glass / hot silver / sputtered ZnO substrate for both absorber layer thicknesses, and a reference cell prepared on rough LPCVD ZnO without any intermediate layer was prepared for the 1.5 µm absorber layer cells.

Hot silver is a substrate which produces the best nip µc-Si:H cells in the laboratory of the applicants.

**Table 1**

| 1.5 micron cells | CVF (%) | Voc (V) | FF | Efficiency |
|---|---|---|---|---|
| Hot silver | 60.5 | 0.514 | 0.721 | 7.69 |
| LPCVD ZnO without polished layer | 50.1 | 0.397 | 0.490 | 3.81 |
| LPCVD ZnO with polished n-a-si CH4 1.2 | 56.6 | 0.522 | 0.730 | 6.64 |
| LPCVD ZnO with polished n-a-si CO2 6 2.5 micron cells | 61 | 0.509 | 0.712 | 6.27 |
| Hot silver | 60.6 | 0.504 | 0.676 | 7.90 |
| LPCVD ZnO with polished CH4 1.2 | 61.1 | 0.522 | 0.693 | 7.59 |
| LPCVD ZnO with polished CO2 6 | 64.2 | 0.512 | 0.678 | 6.88 |

The reference cell prepared on rough LPCVD ZnO without any intermediate layer lost more than 100 mV in V_{oc}, and lost an absolute 20% in FF compared to the two cells prepared with intermediate layers and the reference cell prepared on the in-house hot silver substrate. The cells prepared with an intermediate layer of n-a-Si₁₋ₓCₓ:H had higher V_{oc} and FF than both of the reference cells, gaining over 10 mV in V_{oc} and an absolute 1% in FF compared to the cells prepared on the in-house hot silver substrate. The cells prepared with a intermediate layer of n-a-Si_{1-y}O_{y}:H had similar V_{oc} and FF to the cells prepared on in-house hot silver substrates.

As one will recall, the presence of voids or cracks in the µc-Si:H tends to reduce both V_{oc} and FF. These results indicate that the addition of the intermediate layer and the smoothing process create a flat substrate which facilitates the growth of high quality µc-Si:H material and, by analogy with Figure 2C, eliminates detrimental crack formation in the µc-Si:H material.

## Claims

1. Solar cell comprising a support (6), a back electrode layer (5), at least a hydrogenated microcrystalline silicon photoelectric device (9), and a top electrode layer (11), **characterized in that** the back electrode layer (5) has a rough surface, and **in that** the solar cell comprises, between the back electrode layer (5) and the hydrogenated microcrystalline silicon photoelectric device (9), an asymmetric intermediate layer (8), said intermediate layer (8) being adjacent to said hydrogenated microcrystalline silicon photoelectric device (9) and having a surface, on the side of the back electrode layer (5), having a roughness greater than the roughness of the surface of said intermediate layer (8) on the side of the hydrogenated microcrystalline silicon device (9).

2. Solar cell according to claim 1, **characterized in that** the intermediate layer (8) has an average thickness of between 0.05 µm and 1 µm, preferably between 0.1 µm and 0.4 µm.

3. Solar cell according to anyone of claims 1 to 2, **characterized in that** the intermediate layer (8) has a refractive index n close to that of crystalline silicon (n = 4), n being preferably comprised between 3 to 3.7.

4. Solar cell according to anyone of claims 1 to 3, **characterized in that** the intermediate layer (8) is made of amorphous silicon optionally alloyed with carbon, oxygen, nitrogen or a combination of those.

5. Solar cell according to anyone of claims 1 to 4, **characterized in that** the roughness of the surface of the intermediate layer (8) on the side of the hydrogenated microcrystalline silicon device (9), determined by the standard deviation of the heights of the points constituting its surface, is comprised between 0 nm and 30 nm.

6. Solar cell according to anyone of claims 1 to 4, **characterized in that** the roughness of the surface of the intermediate layer (8) on the side of the hydrogenated microcrystalline silicon device (9), determined by the standard deviation of the heights of the points constituting its surface, is comprised between 10 nm and 200 nm and **in that** the radius of curvature of valleys or pinches is larger than 100 nm.

7. Solar cell according to anyone of claims 1 to 6, **characterized in that** the roughness of the surface of said intermediate layer (8) on the side of the back electrode layer (5), determined by the standard deviation of the heights of the points constituting its surface, is comprised between 50 nm and 300 nm.

8. Solar cell according to claim 7, **characterized in that** the geometry of the intermediate layer (8) on the side of the back electrode layer (5) is such that the lateral feature size is in the range of 200-2000 nm , opening angles in the range of 5-30° and height H corresponding.

9. Solar cell according to anyone of claims 1 to 8, **characterized in that** the support (6) is a substrate on which the back electrode layer (5) is deposited.

10. Solar cell according to claim 9, **characterized in that** it further comprises, between the microcrystalline silicon device (9) and the top electrode layer (11), at least one photoelectric device (13) based on amorphous silicon, in order to form a multi-junction cell.

11. Solar cell according to claim 10, **characterized in that** it further comprises an intermediate reflector being deposited between the photoelectric device (13) based on amorphous silicon and the microcrystalline silicon device (9).

12. Solar cell according to anyone of claims 1 to 5, **characterized in that** the support (6) is transparent, the top electrode layer (11) being deposited on said support and **in that** the solar cell further comprises, between the top electrode layer (11) and the microcrystalline silicon device (9), at least one photoelectric device based on amorphous silicon (13), in order to form a multi-junction cell.

13. Solar cell according to claim 12, **characterized in that** it further comprises an intermediate reflector (15) being deposited between the photoelectric device based on amorphous silicon (13) and the microcrystalline silicon device (9), said intermediate reflector (15) having, on the side of the microcrystalline silicon device (9), a roughness that is not detrimental to the growth of the microcrystalline silicon device (9).

14. Method for producing a solar cell as defined in claims 9 to 11, **characterized in that** it comprises the following steps of:
- providing a substrate (6) on which a textured back electrode layer (5) has been deposited,
- depositing on the textured back electrode layer (5) an intermediate layer (8),
- smoothing the surface of said intermediate layer (8) until to obtain a roughness of the surface of the intermediate layer (8) lower than the roughness of the surface on the side of the textured back electrode layer (5), and
- depositing on the intermediate layer (8) at least one hydrogenated microcrystalline silicon photoelectric device (9), and
- depositing the top electrode layer (11).

15. Method according to claim 14, **characterized in that** the step of smoothing the surface of the intermediate layer (8) is carried out until point contacts with the back electrode layer (5) are created.

16. Method according to anyone of claims 14 to 15, **characterized in that** it further comprises a step of depositing, between the microcrystalline silicon photoelectric device (9) and the top electrode layer (11), at least one photoelectric layer based on amorphous silicon, in order to form a multi-junction cell, incorporating possibly an intermediate reflector between the photoelectric device based on amorphous silicon and the microcrystalline silicon photoelectric device.

17. Method for producing a solar cell as defined in claims 12 to 13, **characterized in that** it comprises the following steps of:
- providing a support (6) on which a top electrode layer (11) has been deposited,
- depositing on the top electrode layer (11) at least one photoelectric device based on amorphous silicon (13),
- depositing at least one hydrogenated microcrystalline silicon photoelectric device (9),
- depositing on said hydrogenated microcrystalline silicon photoelectric device (9) an intermediate layer (8),
- texturing the surface of said intermediate layer (8) until to obtain a roughness of the surface of the intermediate layer (8) greater than the roughness of the surface on the side of the hydrogenated microcrystalline silicon photoelectric device (9), and
- depositing the back electrode layer (5).

18. Method according to claim 17, **characterized in that** it further comprises a step of depositing, between the photoelectric device based on amorphous silicon (13) and the microcrystalline silicon photoelectric device (9), an intermediate reflector (15) having, on the side of the microcrystalline silicon device (9), a roughness that is not detrimental to the growth of the microcrystalline silicon device (9).
